# EUROPÄISCHE PATENTSCHRIFT

(11) **EP 2 727 239 B1**
(45) Veröffentlichungstag und Bekanntmachung des Hinweises auf die Patenterteilung: **14.12.2016**
(21) Anmeldenummer: 12731436.7
(22) Anmeldetag: 29.06.2012
(51) Int. Cl.: H03F 3/68, H03F 1/02

(54) **DOHERTY-VERSTÄRKER MIT WIRKUNGSGRADOPTIMIERUNG**
DOHERTY AMPLIFIER WITH OPTIMISED EFFICIENCY
AMPLIFICATEUR DOHERTY À RENDEMENT OPTIMISÉ

(30) Priorität: 30.06.2011 DE 102011078410; 22.07.2011 DE 102011079613
(43) Veröffentlichungstag der Anmeldung: 07.05.2014
(73) Patentinhaber: Rohde & Schwarz GmbH & Co. KG, 81671 München (DE)
(72) Erfinder: DALISDA, Uwe, 82256 Fürstenfeldbruck (DE); MÜHLBACHER, Peter, 85290 Geisenfeld (DE)
(74) Vertreter: Körfer, Thomas
(86) Internationale Anmeldenummer: PCT/EP2012/062692
(87) Internationale Veröffentlichungsnummer: WO 2013/001059

(56) Entgegenhaltungen:
- EP-A1- 1 758 242
- WO-A1-01/03289
- WO-A1-2008/013481
- WO-A2-2008/042709
- US-A1- 2004 113 698
- US-A1- 2007 008 032
- US-A1- 2007 298 736
- US-A1- 2008 111 622
- US-A1- 2008 122 542
- US-A1- 2008 238 544
- US-B1- 6 285 251
- US-B1- 6 396 341
- US-B1- 7 619 468

## Beschreibung

Die Erfindung betrifft einen Verstärker, insbesondere einen Doherty-Verstärker.

Doherty-Verstärker bestehen üblicherweise aus zwei Verstärkerzweigen, einem Hauptverstärker und einem Hilfsverstärker. Die beiden Ausgänge von Hauptverstärker und Hilfsverstärker werden über eine λ/4-Leitung im Hauptverstärkerzweig zusammengefasst. Der Lastwiderstand transformiert sich somit dynamisch auf Haupt- und Hilfsverstärker, was zu einer Erhöhung des Wirkungsgrades führt. Das zu verstärkende Eingangssignal wird dabei über einen Signalteiler dem Hauptverstärker und dem Hilfsverstärker zugeführt. Die Phasenverschiebung der aufgeteilten Eingangssignale für Hauptverstärker und Hilfsverstärker beträgt dabei 90°, um die Phasenverschiebung im Hauptverstärkerzweig durch die im Ausgang befindliche, notwendige λ/4-Leitungstransformation zu kompensieren.

Ein solcher Doherty-Verstärker ist aus dem europäischen Patent EP 1 609 239 B1 bekannt. Nachteilhaft ist bei dem bekannten Doherty-Verstärker, dass durch die Signalaufteilung sowie durch Toleranzen der Einzelverstärker keine optimale Signaltrennung zwischen Haupt- und Hilfsverstärker stattfindet. Ein reduzierter Wirkungsgrad ist die Folge.

Weiterhin zeigt das Dokument US 2008/0111622 A1 einen Doherty-Verstärker mit einem Hauptverstärker und einem Hilfsverstärker. Auch hier werden die Ausgangssignale der Verstärker mittels eines Kombinierers zu einem gemeinsamen Ausgangssignal zusammengefasst. Den Verstärkern werden dabei jeweils Eingangssignale zugeführt, welche aus einem gemeinsamen Eingangssignal durch Aufteilung des Eingangssignals und entsprechende Vorverarbeitung erzeugt wurden.

Der Erfindung liegt die Aufgabe zu Grunde, einen Verstärker zu schaffen, welcher einen hohen Wirkungsgrad aufweist.

Die Aufgabe wird erfindungsgemäß durch einen Verstärker mit den Merkmalen des unabhängigen Anspruchs 1 gelöst. Vorteilhafte Weiterbildungen sind Gegenstand der hierauf rückbezogenen Unteransprüche.

Ein erfindungsgemäßer Verstärker verfügt über eine Hauptverstärkerschaltung, eine Hilfsverstärkerschaltung und eine Signalerzeugungseinrichtung. Ausgangsanschlüsse der Hauptverstärkerschaltung und der Hilfsverstärkerschaltung sind gemäß dem Doherty-Prinzip verbunden. Die Signalerzeugungseinrichtung ist ausgebildet, um ein Hauptverstärkersignal als Eingangssignal der Hauptverstärkerschaltung und ein Hilfsverstärkersignal als Eingangssignal der Hilfsverstärkerschaltung direkt zu erzeugen. Es wird so ein Verstärker mit sehr hohem Wirkungsgrad erreicht.

Nachfolgend wir die Erfindung anhand der Zeichnung, in der ein vorteilhaftes Ausführungsbeispiel der Erfindung dargestellt ist, beispielhaft beschrieben. In der Zeichnung zeigen:
- Fig. 1: einen beispielhaften Doherty-Verstärker;
- Fig. 2: einen ersten beispielhaften Wirkungsgradverlauf;
- Fig. 3: einen zweiten beispielhaften Wirkungsgradverlauf;
- Fig. 4: ein erstes Ausführungsbeispiel des erfindungsgemäßen Verstärkers;

- Fig. 5: einen ersten Wirkungsgradverlauf bei einem Ausführungsbeispiel des erfindungsgemäßen Verstärkers;
- Fig. 6: ein zweites Ausführungsbeispiel des erfindungsgemäßen Verstärkers, und
- Fig. 7: einen zweiten Wirkungsgradverlauf bei einem Ausführungsbeispiel des erfindungsgemäßen Verstärkers.

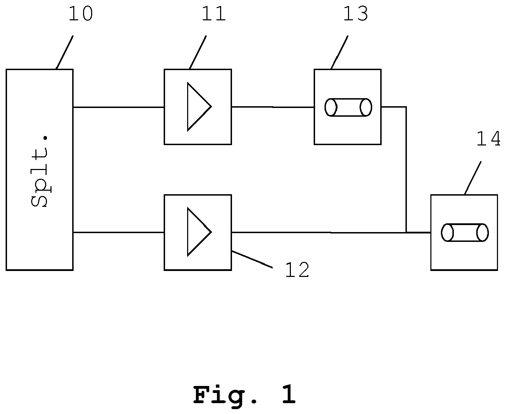

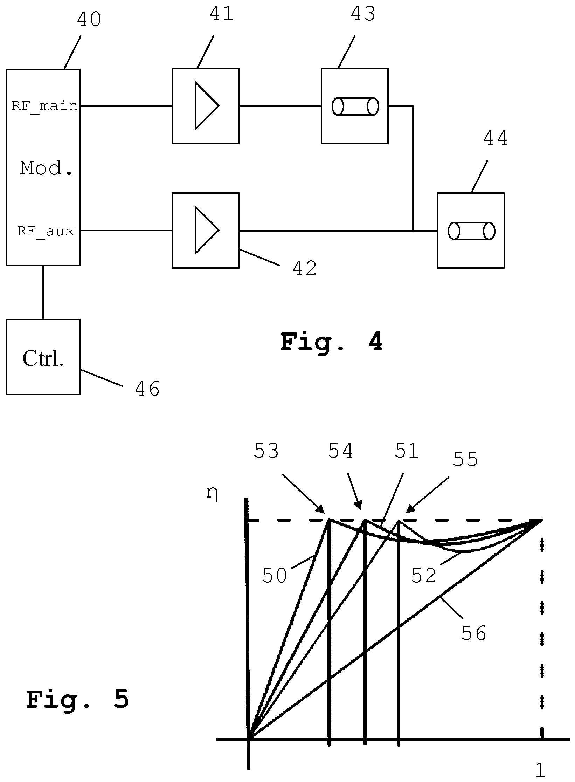

Zunächst wird anhand der Fig. 1 - Fig. 3 die der gegenwärtigen Erfindung zu Grunde liegende Problematik erläutert. Anschließend werden anhand von Fig. 4 - Fig. 7 der Aufbau und die Funktionsweise verschiedener Ausführungsbeispiele des erfindungsgemäßen Verstärkers gezeigt. Identische Elemente wurden in ähnlichen Abbildungen zum Teil nicht wiederholt dargestellt und beschrieben.

Fig. 1 zeigt einen beispielhaften Doherty-Verstärker. Ein Signalteiler 10 ist mit einer Hauptverstärkerschaltung 11 und einer Hilfsverstärkerschaltung 12 verbunden. Die Hauptverstärkerschaltung 11 ist weiterhin mit einer λ/4-Leitung 13 verbunden. Die Hilfsverstärkerschaltung 12 und die λ/4-Leitung 13 sind mit einer weiteren λ/4-Leitung 14 verbunden.

Ein zu verstärkendes Eingangssignal wird dem Signalteiler 10 zugeführt. Dieser teilt es in ein Hauptverstärkersignal und ein Hilfsverstärkersignal auf. Das Hauptverstärkersignal und das Hilfsverstärkersignal weisen dabei einen 90° Phasenversatz auf. Das Hauptverstärkersignal entspricht dabei dem zu verstärkenden Signal. Das Hilfsverstärkersignal entspricht dabei diesen Signalspitzen. Die Hauptverstärkerschaltung 11 verstärkt das Hauptverstärkersignal, während die Hilfsverstärkerschaltung 12 das Hilfsverstärkersignal verstärkt.

Die λ/4-Leitung 13 im Hauptverstärkerpfad führt eine Leitungstransformation durch. Hierdurch findet eine dynamische Lastwiderstandtransformation derart statt, dass die Hauptverstärkerschaltung 11 bei einem Schwellwert, üblicherweise 6 dB, in die Sättigung geht. Bei weiterer Leistungserhöhung liefert die Hilfsverstärkerschaltung ebenfalls einen Beitrag zur Ausgangsleistung, was zur dynamischen Absenkung des Lastwiderstands für die Hauptverstärkerschaltung 11 führt. Bei Vollausteuerung liefern beide Verstärker je 50% der Gesamtleistung.

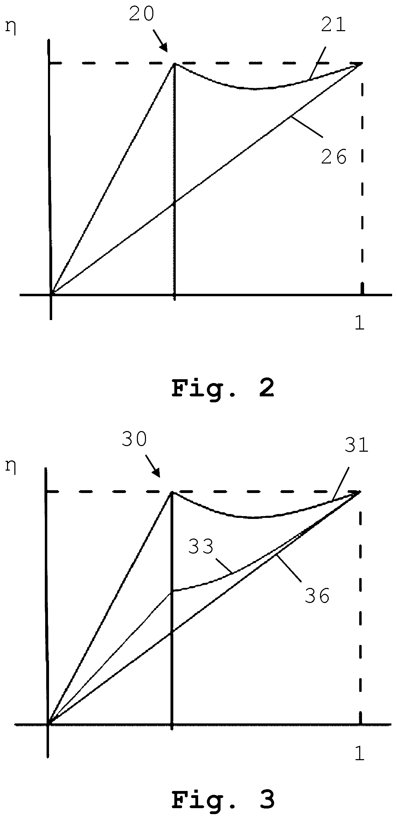

Für den Doherty-Verstärker nach Fig. 1 ergibt sich dann der in Fig. 2 gezeigte theoretische Wirkungsgradverlauf 21. Bei dem eingestellten Schwellwert 20 geht die Hauptverstärkerschaltung in die Sättigung. Bis zu diesem Punkt liefert die Hilfsverstärkerschaltung keinen Beitrag zur Ausgangsleistung. Zum Vergleich ist hier zusätzlich der Wirkungsgradverlauf 26 eines Klasse B Verstärkers eingezeichnet.

Durch die Signalteilung im Eingang, sowie durch Toleranzen der Einzelverstärker, unterschiedliche Ruhestromeinstellung der Verstärker etc., kann keine optimale Signaltrennung zwischen der Hauptverstärkerschaltung und der Hilfsverstärkerschaltung stattfinden. Teilweise liefert die Hilfsverstärkerschaltung schon Leistung, obwohl die Hauptverstärkerschaltung noch nicht in der Sättigung ist. Deshalb wird die Spitzeneffizienz im Bereich des Schwellwerts nicht zuverlässig erreicht. Dies ist in Fig. 3 dargestellt. Der Wirkungsgradverlauf 31 entspricht dem Wirkungsgradverlauf 21 aus Fig. 2. Ein realer erreichbarer Wirkungsgradverlauf 33 ist zusätzlich dargestellt. Zum Vergleich ist weiterhin der Wirkungsgradverlauf 36 eines üblichen Klasse B Verstärkers dargestellt. Gegenüber diesem Klasse B Verstärker erreicht der Wirkungsgradverlauf 33 des realen Doherty-Verstärkers jedoch noch immer einen deutlich höheren mittleren Wirkungsgrad.

In Fig. 4 ist ein erstes Ausführungsbeispiel des erfindungsgemäßen Verstärkers dargestellt. Eine Signalerzeugungseinrichtung 40 ist mit einer Hauptverstärkerschaltung 41 und einer Hilfsverstärkerschaltung 42 verbunden. Die Hauptverstärkerschaltung 41 ist weiterhin mit einer λ/4-Leitung 43 verbunden. Die λ/4-Leitung 43 und die Hilfsverstärkerschaltung 42 sind mit einer weiteren λ/4-Leitung 44 verbunden. Die Signalerzeugungseinrichtung 40 ist weiterhin mit einer Steuereinrichtung 46 verbunden.

Anstatt ein analoges zu verstärkendes Signal in ein Hauptverstärkersignal und ein Hilfsverstärkersignal aufzuteilen, wie dies durch den Signalteiler 10 aus Fig. 1 erfolgt, wird hier durch die Signalerzeugungseinrichtung 40 ein Hauptverstärkersignal und ein Hilfsverstärkersignal erzeugt. Die Erzeugung kann dabei aus digitalen zu verstärkenden Signalen erfolgen. Vorteilhafterweise erfolgt die Signalerzeugung dabei direkt. Vorteilhafterweise handelt es sich bei der Signalerzeugungseinrichtung um eine Modulationseinrichtung oder einen Steuersender. Das Hauptverstärkersignal und das Hilfsverstärkersignal werden dabei von der Signalerzeugungseinrichtung 40 bereits mit einem 90° Phasenversatz erzeugt.

Die Steuereinrichtung 46 steuert dabei die Signalerzeugungseinrichtung 40. So stellt sie den Schwellwert ein, bei welchem die Signalerzeugungseinrichtung 40 das zu verstärkende Signal in das Hauptverstärkersignal und das Hilfsverstärkersignal aufteilt. In Abhängigkeit dieses Schwellwerts kann die Steuereinrichtung 46 somit unterschiedliche Wirkungsgradverläufe einstellen. Hierauf wird anhand von Fig. 5 näher eingegangen.

In Fig. 5 werden mehrere Wirkungsgradverläufe 50, 51, 52 resultierend aus mehreren unterschiedlichen Schwellwerten 53, 54, 55 gezeigt. Durch Einstellung dieser Schwellwerte 53, 54, 55 stellt die Steuereinrichtung 46 aus Fig. 4 gleichzeitig auch die jeweiligen Wirkungsgradverläufe 50, 51, 52 ein. Zum Vergleich ist hier zusätzlich der Wirkungsgradverlauf 56 eines herkömmlichen Klasse B Verstärkers aufgetragen.

Durch den Verzicht auf einen analogen Signalteiler wird so eine deutliche Verbesserung des Wirkungsgrads erreicht. Die erzielbaren Wirkungsgradverläufe 50, 51, 52 liegen nahe bei dem theoretisch maximal erzielbaren Wirkungsgradverlauf. Darüber hinaus ist durch Einstellung des Schwellwerts eine Optimierung für das gegenwärtig zu verstärkende Signal möglich. So könnte für Signale mit sehr hohen Spitzenwerten gegenüber dem Signalmittelwert, beispielsweise 9-12 dB, vorzugsweise 10 dB, ein Wirkungsgradverlauf 50 eingestellt werden. Bei Signalen mit hohen Spitzenwerten gegenüber dem Signalmittelwert, beispielsweise 7-9 dB, vorzugsweise 8 dB, könnte ein Wirkungsgradverlauf 51 eingestellt werden. Bei Signalen mit weniger hohen Spitzenwerten gegenüber dem Signalmittelwert, beispielsweise 5-7 dB, vorzugsweise 6 dB, könnte ein Wirkungsgradverlauf 52 eingestellt werden.

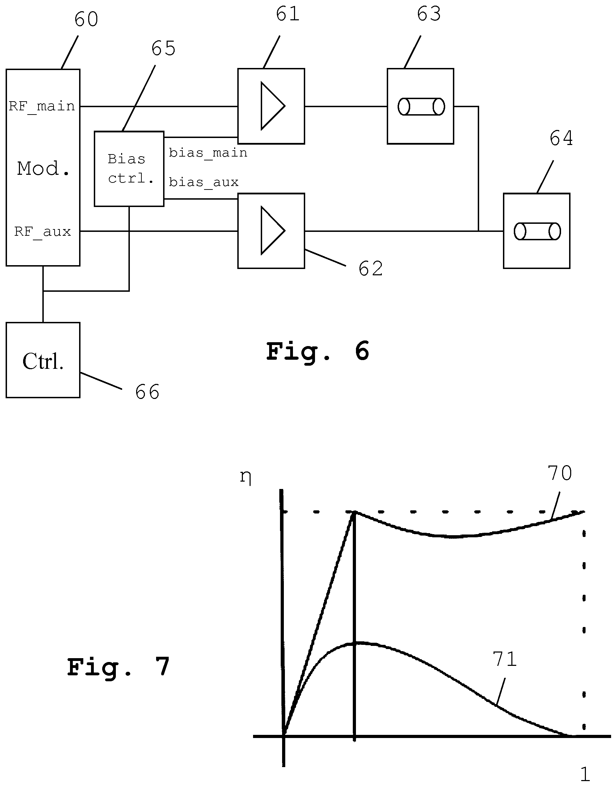

In Fig. 6 wird ein zweites Ausführungsbeispiel des erfindungsgemäßen Verstärkers gezeigt. Der dargestellte Verstärker entspricht weitgehend dem Verstärker aus Fig. 4. Die Bezugszeichen 60-64 und 66 entsprechen den Bezugszeichen 40-44 und 46 aus Fig. 4. Zusätzlich beinhaltet der hier gezeigte Verstärker eine Ruhestromerzeugungseinrichtung 65. Diese ist mit der Steuereinrichtung 66, der Hauptverstärkerschaltung 61 und der Hilfsverstärkerschaltung 62 verbunden. Die Ruhestromerzeugungseinrichtung 65 erzeugt dabei den Ruhestrom bias_main der Hauptverstärkerschaltung 61 und den Ruhestrom bias_aux der Hilfsverstärkerschaltung 62. Die Erzeugung der Ruheströme bias_main und bias_aux erfolgt dabei in Abhängigkeit des gewünschten Schwellwerts der Signalaufteilung. Die Bestimmung der zu erzeugenden Ruheströme bias-main und bias_aux erfolgt auch durch die Steuereinrichtung 66. Eine weitere Annäherung des Wirkungsgradverlaufs an den maximal theoretisch erreichbaren Wirkungsgradverlauf wird so erreicht.

Insbesondere vorteilhaft ist der in Fig. 4 und Fig. 6 gezeigte Verstärker bei der Verstärkung von Signalen mit digitaler Modulation (z.B. QAM-OFDM, COFDM, etc.). Diese digitalen Modulationsarten finden Verwendung in vielen Applikationen. Beispielhaft sollen hier DVB-T, DVB-H, DVB-T2, MediaFlo, ISDB-T, ATSC, CMMB, CDMA, WCDMA, GSM, etc. genannt sein. Diese Modulationsarten verfügen über unterschiedliche Crest-Faktoren, bzw. über unterschiedliche Signalstatistiken. Die Signalstatistik dieser Signale ist entweder bekannt, kann gemessen werden, oder kann bei der Signalerzeugung berechnet werden. Das Hauptverstärkersignal und das Hilfsverstärkersignal können nun so berechnet werden, dass der Punkt mit dem höchsten Spitzenwirkungsgrad optimal zur Signalstatistik abgestimmt ist, um einen maximalen Summenwirkungsgrad der Verstärkeranordnung zu erreichen. Dies ist in Fig. 7 dargestellt. So zeigt die Kurve 71 eine statistische Amplitudenverteilung eines eingesetzten Modulationsverfahrens. Der Wirkungsgradverlauf 70, welcher durch die Steuereinrichtung 46 bzw. 66 aus Fig. 4 bzw. Fig. 6 einbestellt wird, maximiert den durchschnittlichen Summenwirkungsgrad der auszusendenden Sendesymbole.

Eine geringfügige weitere Verbesserung des durchschnittlichen Wirkungsgrads kann durch dauerhafte Überwachung der Statistik des auszusendenden Signals und eine Anpassung des einzustellenden Wirkungsgradverlaufs erreicht werden.

Die Erfindung ist nicht auf das dargestellte Ausführungsbeispiel beschränkt. Neben den bereits erwähnten Modulationsverfahren sind auch andere Übertragungsverfahren denkbar. Alle vorstehend beschriebenen Merkmale oder in den Figuren gezeigten Merkmale sind im Rahmen der Erfindung beliebig vorteilhaft miteinander kombinierbar.

## Patentansprüche

1. Verstärker mit einer Hauptverstärkerschaltung (41, 61) und einer Hilfsverstärkerschaltung (42, 62),
wobei Ausgangsanschlüsse der Hauptverstärkerschaltung (41, 61) und der Hilfsverstärkerschaltung (42, 62) gemäß dem Doherty-Prinzip verbunden sind,
wobei der Verstärker weiterhin eine Signalerzeugungseinrichtung (40, 60) beinhaltet, welche ausgebildet ist, um ein Hauptverstärkersignal als Eingangssignal der Hauptverstärkerschaltung (41, 61) und ein Hilfsverstärkersignal als Eingangssignal der Hilfsverstärkerschaltung (42, 62) direkt zu erzeugen, wobei die Signalerzeugungseinrichtung (40, 60) ausgebildet ist, um das Hauptverstärkersignal und das Hilfsverstärkersignal durch Modulation und/oder aus zu sendenden digitalen Daten zu erzeugen,
wobei das Hauptverstärkersignal einem zu verstärkenden Signal entspricht,
wobei das Hilfsverstärkersignal den Signalspitzen des zu verstärkenden Signals entspricht,
**dadurch gekennzeichnet**
**dass** der Verstärker weiterhin eine Steuereinrichtung (46, 66) beinhaltet,
**dass** die Steuereinrichtung (46, 66) ausgebildet ist, um die Signalerzeugungseinrichtung (40, 60) zu steuern, und dass die Steuereinrichtung (46, 66) ausgebildet ist, um anhand des zu verstärkenden Signals einen Schwellwert (53, 54, 55) zur Bestimmung des Hauptverstärkersignals und des Hilfsverstärkersignals zu bestimmen.

2. Verstärker nach Anspruch 1,
**dadurch gekennzeichnet,**
**dass** die Signalerzeugungseinrichtung (40, 60) ein Modulator oder Steuersender ist.

3. Verstärker nach Anspruch 1 oder 2,
**dadurch gekennzeichnet,**
**dass** das Hauptverstärkersignal und das Hilfsverstärkersignal phasenverschoben sind.

4. Verstärker nach Anspruch 1,
**dadurch gekennzeichnet,**
**dass** die Steuereinrichtung (46, 66) ausgebildet ist, um den Schwellwert (53, 54, 55) anhand von statistischen Vorabinformationen, das zu verstärkende Signal betreffend, wirkungsgradoptimierend einzustellen.

5. Verstärker nach einem der Ansprüche 1 bis 4,
**dadurch gekennzeichnet,**
**dass** der Verstärker weiterhin eine Ruhestromerzeugungseinrichtung (65) beinhaltet, und
**dass** die Ruhestromerzeugungseinrichtung (65) ausgebildet ist, um Ruheströme der Hauptverstärkerschaltung (61) und der Hilfsverstärkerschaltung (62) zu erzeugen.

6. Verstärker nach Anspruch 5,
**dadurch gekennzeichnet,**
**dass** die Steuereinrichtung (66) ausgebildet ist, um die Ruhestromerzeugungseinrichtung (65) zu steuern.

7. Verstärker nach Anspruch 5 oder 6,
**dadurch gekennzeichnet,**
**dass** die Steuereinrichtung (66) ausgebildet ist, um die Ruheströme der Hauptverstärkerschaltung (61) und der Hilfsverstärkerschaltung (62) anhand von statistischen Vorabinformationen, das zu verstärkende Signal betreffend, wirkungsgradoptimierend einzustellen.

8. Verstärker nach einem der Ansprüche 1 bis 7,
**dadurch gekennzeichnet,**
**dass** die Steuereinrichtung (46, 66) ausgebildet ist, um einen mittleren Wirkungsgrad über eine Gesamtheit auszusendender Sendesymbole zu maximieren.

## Claims

1. Amplifier with a main amplifier circuit (41, 61) and an auxiliary amplifier circuit (42, 62),
wherein output connections of the main amplifier circuit (41, 61) and of the auxiliary amplifier circuit (42, 62) are connected according to the Doherty principle,
wherein the amplifier also comprises a signal producing device (40, 60) which is configured directly to produce a main amplifier signal as input signal for the main amplifier circuit (41, 61) and an auxiliary amplifier signal as input signal for the auxiliary amplifier circuit (42, 62),
wherein the signal producing device (40, 60) is configured to produce the main amplifier signal and the auxiliary amplifier signal by modulation and/or from digital data to be transmitted,
wherein the main amplifier signal corresponds to a signal to be amplified,
wherein the auxiliary amplifier signal corresponds to the signal peaks of the signal to be amplified,
**characterised in that**
the amplifier also comprises a control device (46, 66),
**in that** the control device (46, 66) is configured to control the signal producing device (40, 60), and
**in that** the control device (46, 66) is configured to use the signal to be amplified to define a threshold value (53, 54, 55) to define the main amplifier signal and the auxiliary amplifier signal.

2. Amplifier according to claim 1,
**characterised in that**
the signal producing device (40, 60) is a modulator or control transmitter.

3. Amplifier according to claim 1 or 2,
**characterised in that**
the main amplifier signal and the auxiliary amplifier signal are phase-shifted.

4. Amplifier according to claim 1,
**characterised in that**
the control device (46, 66) is configured to adjust the threshold value (53, 54, 55) by reference to statistical advance information relating to the signal to be amplified for optimum efficiency.

5. Amplifier according to one of claims 1 to 4,
**characterised in that**
the amplifier also comprises a closed-circuit current producing device (65), and
**in that** the closed-circuit current producing device (65) is configured to produce closed-circuit currents of the main amplifier circuit (61) and of the auxiliary amplifier circuit (62).

6. Amplifier according to claim 5,
**characterised in that**
the control device (66) is configured to control the closed-circuit current producing device (65).

7. Amplifier according to claim 5 or 6,
**characterised in that**
the control device (66) is configured to adjust the closed-circuit currents of the main amplifier circuit (61) and of the auxiliary amplifier circuit (62) by reference to statistical advance information relating to the signal to be amplified for optimum efficiency.

8. Amplifier according to one of claims 1 to 7,
**characterised in that**
the control device (46, 66) is configured to maximise an average efficiency over a whole [series] of transmission symbols to be transmitted.

## Revendications

1. Amplificateur comprenant un circuit d'amplificateur principal (41, 61) et un circuit d'amplificateur auxiliaire (42, 62), dans lequel les bornes de sortie du circuit d'amplificateur principal (41, 61) et du circuit d'amplificateur auxiliaire (42, 62) sont reliées conformément au principe de Doherty,
dans lequel l'amplificateur contient en outre un dispositif de génération de signaux (40, 60), lequel est conçu pour générer directement un signal d'amplificateur principal en tant que signal d'entrée du circuit d'amplificateur principal (41, 61) et un signal d'amplificateur auxiliaire en tant que signal d'entrée du circuit d'amplificateur auxiliaire (42, 62),
dans lequel le dispositif de génération de signaux (40, 60) est conçu pour générer le signal d'amplificateur principal et le signal d'amplificateur auxiliaire par modulation et/ou à partir des données numériques à envoyer,
dans lequel le signal d'amplificateur principal correspond à un signal à amplifier,
dans lequel le signal d'amplificateur auxiliaire correspond aux pics de signal du signal à amplifier,
**caractérisé en ce que**
l'amplificateur contient en outre un dispositif de commande (46, 66),
le dispositif de commande (46, 66) est conçu pour commander le dispositif de génération de signaux (40, 60), et
le dispositif de commande (46, 66) est conçu pour déterminer, sur la base du signal à amplifier, une valeur seuil (53, 54, 55) pour la détermination du signal d'amplificateur principal et du signal d'amplificateur auxiliaire.

2. Amplificateur selon la revendication 1,
**caractérisé en ce que**
le dispositif de génération de signaux (40, 60) est un modulateur ou un émetteur de commande.

3. Amplificateur selon la revendication 1 ou 2, **caractérisé en ce que**
le signal d'amplificateur principal et le signal d'amplificateur auxiliaire sont déphasés.

4. Amplificateur selon la revendication 1,
**caractérisé en ce que**
le dispositif de commande (46, 66) est conçu pour régler la valeur seuil (53, 54, 55) avec optimisation du rendement sur la base des informations préalables statistiques concernant le signal à amplifier.

5. Amplificateur selon l'une quelconque des revendications 1 à 4,
**caractérisé en ce que**
l'amplificateur contient en outre un dispositif de génération de courant de repos (65), et
le dispositif de génération de courant de repos (65) est conçu pour générer des courants de repos du circuit d'amplificateur principal (61) et du circuit d'amplificateur auxiliaire (62).

6. Amplificateur selon la revendication 5,
**caractérisé en ce que**
le dispositif de commande (66) est conçu pour commander le dispositif de génération de courant de repos (65).

7. Amplificateur selon la revendication 5 ou 6,
**caractérisé en ce que**
le dispositif de commande (66) est conçu pour régler les courants de repos du circuit d'amplificateur principal (61) et du circuit d'amplificateur auxiliaire (62) avec optimisation du rendement sur la base d'informations préalables statistiques, concernant le signal à amplifier.

8. Amplificateur selon l'une quelconque des revendications 1 à 7,
**caractérisé en ce que**
le dispositif de commande (46, 66) est conçu pour augmenter au maximum un rendement moyen sur toute l'étendue d'un ensemble de symboles d'émission à émettre.
